(19) Europäisches Patentamt
European Patent Office
Office européen des brevets

(11) **EP 1 045 517 A2**

(12) **EUROPEAN PATENT APPLICATION**

(43) Date of publication:
**18.10.2000 Bulletin 2000/42**

(51) Int. Cl.7: **H03H 9/58**, H03H 9/17

(21) Application number: **00108165.2**

(22) Date of filing: **13.04.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **16.04.1999 JP 10890599**
**01.02.2000 JP 2000023706**

(71) Applicant:
**Murata Manufacturing Co., Ltd.**
**Nagaokakyo-shi Kyoto-fu 617-8555 (JP)**

(72) Inventors:
• **Yamamoto, Takashi**
**Nagaokakyo-shi, Kyoto-fu 617-8555 (JP)**
• **Futamata, Tsuyoshi**
**Nagaokakyo-shi, Kyoto-fu 617-8555 (JP)**

(74) Representative:
**Laufhütte, Dieter, Dr.-Ing. et al**
**Lorenz-Seidler-Gossel**
**Widenmayerstrasse 23**
**80538 München (DE)**

(54) **Ladder-type filter and communication device using the same**

(57)     A ladder-type filter contains a broad-band filter and narrow-band filter, and the output terminal of the broad-band filter is switched to an output terminal or the narrow-band filter by a switch. In the signal processing circuit of a communication device, the output signal of a mixer circuit is input into the broad-band filter of the ladder-type filter. By changing the switch, the output signal of the broad-band filter is made to be output from the output terminal directly or through the narrow-band filter. The broad-band filter and narrow-band filter are desirable to be formed on one substrate.

EP 1 045 517 A2

**Description**

1. Field of the Invention

This invention relates to a ladder-type filter and a communication device using the same and more particularly to, for example, a ladder-type filter to be used in a signal processing circuit of communication devices and a communication device using the same.

2. Description of the Related Art

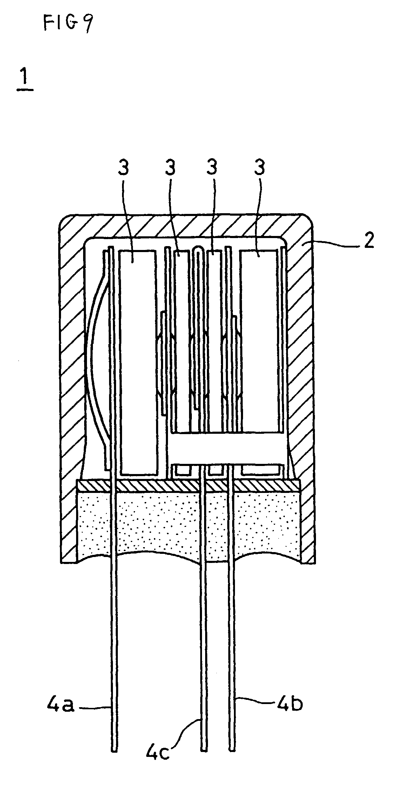

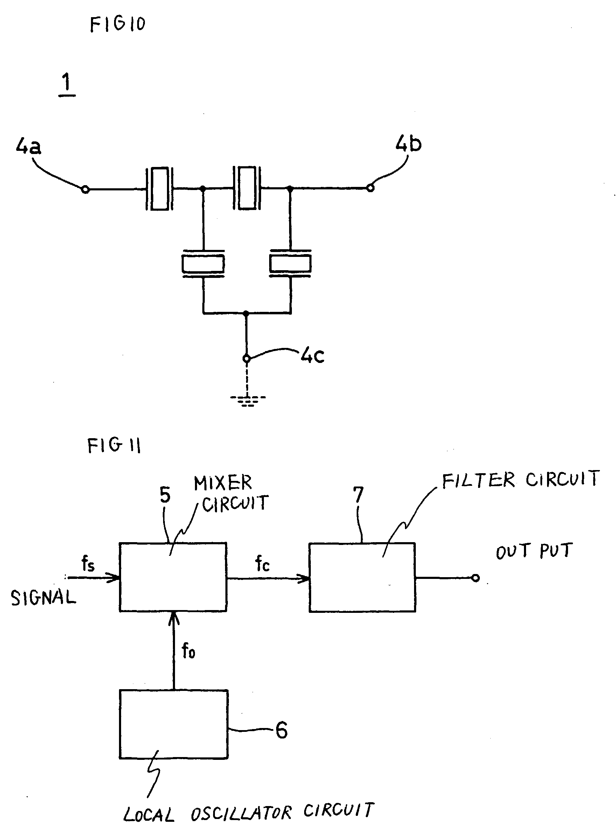

Fig. 9 is a schematic illustration showing one example of conventional ladder-type filters. The ladder-type filter 1 contains a case 2, and four piezoelectric resonators 3 are arranged in the case 2. These piezoelectric resonators are connected in series and in parallel as a ladder-type as shown in Fig. 10. For the piezoelectric resonator to be used in such a ladder-type filter 1, for example, a piezoelectric resonator having spreading vibration is used. And an input terminal 4a, output terminal 4b, and grounding terminal 4c are led out from the case 2 so that they are extended out of the case 2.

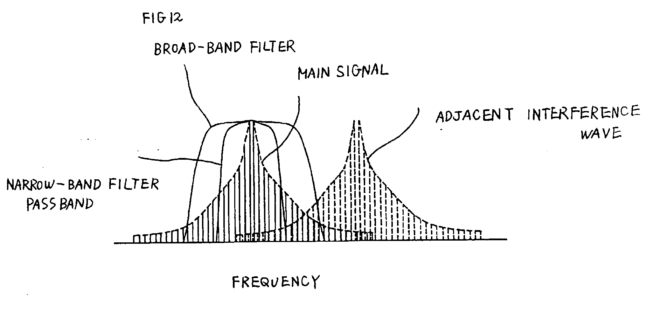

Such a ladder-type filter 1 is used, for example, in a signal processing circuit of an intermediate-frequency stage of a communication device shown in Fig. 11. A signal received is input into a mixer circuit 5. Further, to the mixer circuit 5 a signal generated at a local oscillator circuit 6 is input and mixed with the received signal. Here, when the frequency of the received signal is represented by $f_s$ and the frequency of the signal generated at the local oscillator circuit 6 by $f_0$, an intermediate-frequency signal having the frequency of $f_c$ $(= |f_s - f_0|)$ is output from the mixer circuit 5. Although any value can be used as the frequency $f_c$ of the intermediate-frequency signal, it is common to select 450 kHz. This intermediate-frequency signal is input into the filter circuit 7, only the main signal is taken out by eliminating unwanted signals, and this main signal is sent to the next low-frequency processing circuit.

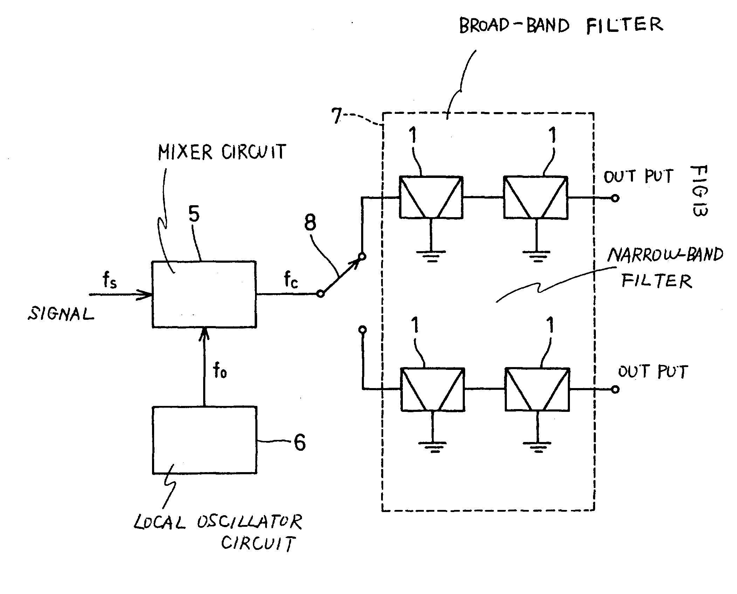

Here, the existence of adjacent interference signals is common in the vicinity of the main signal as shown in Fig. 12, and in order to eliminate these efficiently a narrow-band filter is used. When the narrow-band filter is used, the adjacent interference signals can be eliminated, but at the same time the component of the main signal is also removed. Because of this, as a result a distorted signal different from the reception signal is generated. In order to avoid this, it is required to use a broad-band filter, but if the broad-band filter is used, the adjacent interference signals cannot be fully removed.

What has been worked out as a means of settling such a situation and is in the mainstream of designing is the technique of using a broad-band filter and narrow-band filter properly in accordance with the receiving conditions. For example, as shown in Fig. 13, a filter circuit 7 is composed of a broad-band filter made up of two ladder-type filters 1 and a narrow-band filter made up of two ladder-type filters 1, and it is made possible to switch between them by a manual or automatic switch 8. When such a filter circuit 7 is used, a filtering characteristic in agreement with the receiving conditions can be realized by shifting the switch 8.

However, in the filter circuit of such a communication device many ladder-type filters are required, and the number of parts goes up, the circuit cost rises, and the occupied space increases, and as a result it was difficult to make the communication device small-sized.

It is an object of this invention to present a ladder-type filter in which the number of parts can be decreased, and, further, to present a ladder-type filter which makes it possible to integrate a broad-band filter and narrow-band filter into one component part and to reduce the circuit cost and occupied space.

Further, it is an object of this invention to present a communication device of small size which uses the above ladder-type filter.

In this invention, a ladder-type filter comprises a broad-band filter where a plurality of piezoelectric resonators are connected in series and in parallel as a ladder-type, one narrow-band filter having nearly the same center-frequency as the broad-band filter where a plurality of piezoelectric resonators are connected in series and in parallel as a ladder-type, and a switch for shifting so as to output an output signal of the broad-band filter directly or through the narrow-band filter, wherein by making the signal from the broad-band filter output through the narrow-band filter the total functions as a narrow-band filter.

In such a ladder-type filter, it is desirable to form a broad-band filter and narrow-band filter on one substrate.

Further, in such a ladder-type filter, as the piezoelectric resonator to be used in a broad-band filter and narrow-band filter, a piezoelectric resonator having a basic component where a plurality of piezoelectric layers and internal electrodes are alternately laminated in the length direction, having the piezoelectric layers polarized in the length direction of the basic component, and vibrating in the length direction of the basic component by applying an electric field between the neighboring internal electrodes can be used.

In such a laminated-type piezoelectric resonator two external electrodes alternately connected to a plurality of internal electrodes and formed on the same surface are contained, and the two external electrodes are connected to pattern electrodes formed on the substrate.

Further, the broad-band filter is constructed by connecting four piezoelectric resonators as a ladder-type, and the narrow-band filter can be constructed by connecting two piezoelectric resonators as a ladder-type.

Further, in this invention, a communication device containing a ladder-type filter comprises any one of the above ladder-type filters.

By shifting the switch, the whole can be used as a broad-band filter and can be also used as a narrow-band filter. When this ladder-type filter is used as a narrow-band filter as a whole, the output signal of the broad-band filter can be output through one narrow-band filter, and the number of stages of narrow-band filters can be reduced compared with the case where the signal is output through only the narrow-band filters without making the signal pass through the broad-band filter.

In such a ladder-type filter, by forming a broad-band filter and narrow-band filter on one substrate they can be made one component part, and accordingly the circuit cost and occupied space can be reduced.

When a laminated type is used as a piezoelectric resonator to be used in such a ladder-type filter, for example, by changing the number of lamination, electric characteristics can be adjusted without changing the outer dimension.

In such a laminated-type piezoelectric resonator, two external electrodes are formed on the same surface, by using these external electrodes the piezoelectric resonator can be surface-mounted on the pattern-electrodes formed on the substrate and a broad-band filter and narrow-band filter of a ladder-type are formed.

Further, by connecting four piezoelectric resonators of a laminated type as a ladder-type a broad-band filter can be formed, and by connecting two piezoelectric resonators as a ladder-type a narrow-band filter can be formed.

By using the above ladder-type filters, a small-sized communication device can be obtained compared with the communication device using the conventional ladder-type filters.

The above-mentioned objects, other objects, characteristics, and advantages of this invention will be made more clear by detailed explanation of the following embodiments of the invention with reference to the drawings.

Fig. 1 is an exploded perspective view showing one example of a filter portion to be used in a ladder-type filter of this invention;

Fig. 2 is a schematic illustration showing one example of a piezoelectric resonator to be used in the filter portion shown in Fig. 1;

Fig. 3 is a circuit diagram of the filter portion shown in Fig. 1;

Fig. 4 is a block diagram of the signal processing circuit of a communication device using a ladder-type filter of this invention;

Fig. 5 is a block diagram of the signal processing circuit of a communication device using another ladder-type filter of this invention;

Fig. 6 shows the frequency characteristic of a broad-band filter of a ladder-type filter shown in an embodiment;

Fig. 7 shows the frequency characteristic of a separate narrow-band filter of a ladder-type shown in an embodiment;

Fig. 8 shows the frequency characteristic at the time when the output signal of a broad-band filter of a ladder-type filter shown in an embodiment is made to pass through a narrow-band filter;

Fig. 9 is a schematic illustration showing one example of conventional ladder-type filters;

Fig. 10 is a circuit diagram of the conventional ladder-type filter shown in Fig. 9;

Fig. 11 is a block diagram showing the signal processing circuit of a communication device;

Fig. 12 is the frequency distribution showing the state of the output signal of the mixer circuit shown in Fig. 11; and

Fig. 13 is a block diagram showing an example where in the signal processing circuit shown in Fig. 11 the filter circuit is constructed using the conventional ladder-type filter shown in Fig. 9.

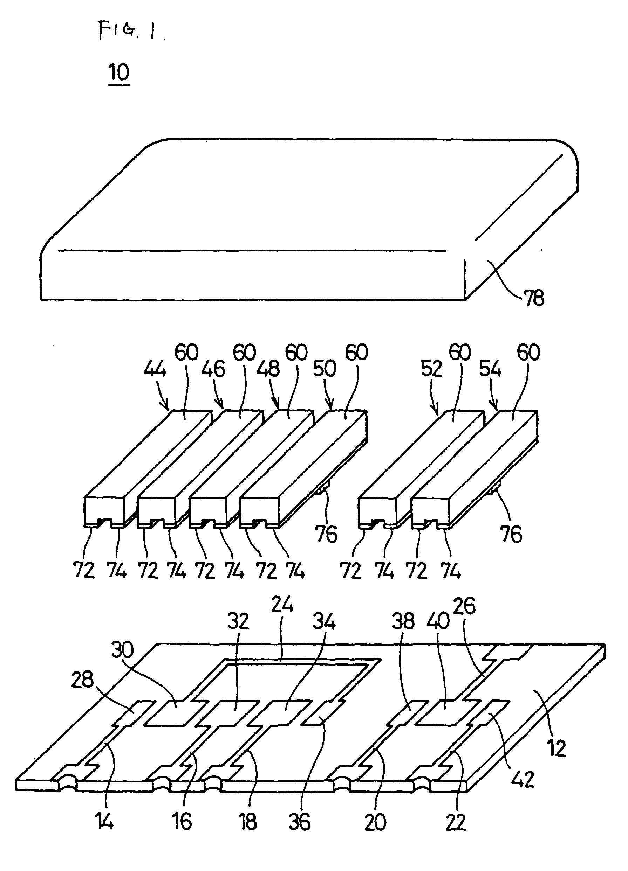

Fig. 1 is an exploded perspective view showing one example of a filter portion constituting a ladder-type filter of this invention. The filter portion 10 contains a insulator substrate 12. As such a substrate, a single-layer substrate, or multilayer substrate, etc. may be used. On the insulator substrate 12, seven pattern electrodes 14, 16, 18, 20, 22, 24, and 26 are formed. The pattern electrodes 14, 16, 18, 20, and 22 are lead out to one end of the insulator substrate 12. Further, the pattern electrode 24 is formed so that the electrode is extended in parallel with the end portion of the insulator substrate 12 on the side of the other end of the insulator substrate 12. Furthermore, the pattern electrode 26 is lead out to the other end of the insulator substrate 12.

Further, eight lands 28, 30, 32, 34, 36, 38, 40, and 42 are formed so that the pattern electrodes 14, 16, 18, 20, and 22 and the pattern electrodes 24 and 26 are spaced. The first land 28 is connected to the pattern electrode 14, the second and fifth land 30 and 36 are connected to the pattern electrode 24, the third land 32 is connected to the pattern electrode 16, and the fourth land 34 is connected to the pattern electrode 18. Further, the sixth land 38 is connected to the pattern electrode 20, the seventh land 40 is connected to the pattern electrode 26, and the eighth land 42 is connected to the pattern electrode 22.

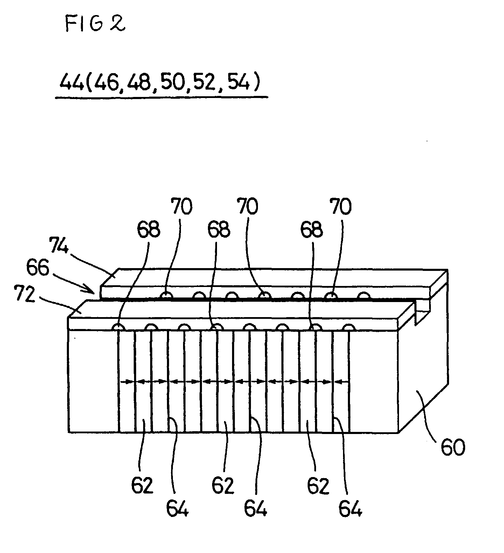

On these lands 28 through 42 six piezoelectric resonators 44, 46, 48, 50, 52, and 54 are mounted. The piezoelectric resonator 44 contains a basic component 60 of a rectangular solid as shown in Fig. 2. The basic component 60 is formed by laminating a plurality of piezoelectric layers 62 and internal electrodes 64. At this time, the main surfaces of the piezoelectric layers 62 and internal electrodes 64 are arranged so as to be a right angle to the length direction of the basic component. And as shown by the arrow in Fig. 2, the neighboring piezoelectric layers 62 on both sides of one internal electrode 64 are polarized in opposite direction from each other in the length direction of the basic component 60.

On one side surface of the basic component 60, a groove 66 extended in the length direction is formed in the middle of the width direction. On one side of the groove 66, the exposure portion of the internal electrode 64 is alternately covered by a insulator 68. Further, on the other side of the groove 66, the exposure portion of the internal electrode which is not covered by the insulator 68 is covered by a insulator 70. Therefore, on both sides of the groove 66, the different internal electrodes 64 are covered by the insulators 68 and 70. Further, on both sides of the groove 66, external electrodes 72 and 74 are formed, respectively. Therefore, to the external electrodes 72 and 74, the neighboring internal electrodes 64 are alternately connected.

The other piezoelectric resonators 46, 48, 50, 52, and 54 have the same construction as the piezoelectric resonator 44. In such piezoelectric resonators, by inputting a signal to the external electrodes 72 and 74 as input terminals, an electric field is applied between the internal electrodes 64. At this time, because the internal electrodes 64 are alternately connected to the external electrodes 72 and 74, to the neighboring piezoelectric layers 62 electric fields on opposite direction to each other are applied. As the neighboring piezoelectric layers 62 are polarized in opposite direction from each other, these signals make the basic component 60 vibrate in a vibration mode in the thickness direction as a whole.

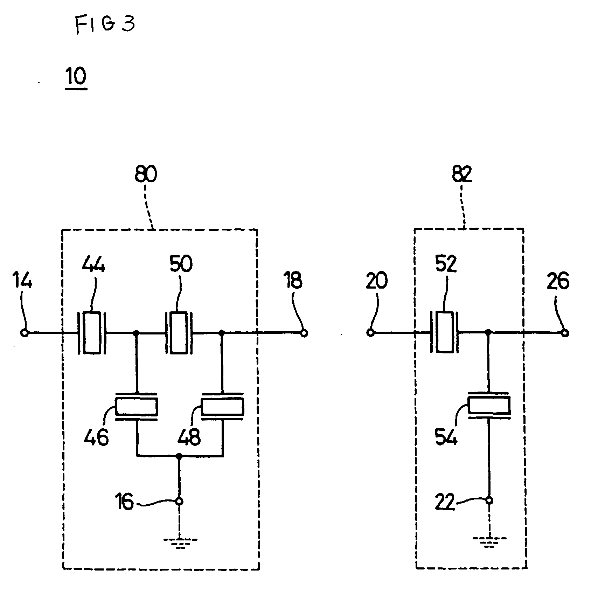

The piezoelectric resonators 44, 46, 48, 50, 52, and 54 in such a vibration mode in the thickness direction are connected as a ladder-type so as to become in series and in parallel as shown in Fig. 3. In this case, in the middle of the external electrodes 72 and 74 of the piezoelectric resonators 44 through 54 a conductor material 76 is formed and this conductor material 76 is connected to the lands 28 through 42. Thus, by making the piezoelectric resonators 44 through 54 float from the insulator substrate 12, a space for the piezoelectric resonators 44 through 54 to vibrate can be ensured. Further, on the insulator substrate 12 a metal cap 78 is put so as to cover the piezoelectric resonators 44 through 54. Furthermore, so as to make the pattern electrodes 14 through 26 not short-circuited an insulating film is formed on the portion with which the cup on the insulator substrate 12 is made in contact.

In this filter portion 10, by the four piezoelectric resonators 44, 46, 48, and 50 connected as a ladder-type a broad-band filter 80 is formed. Further, by the piezoelectric resonators 52 and 54 connected as a ladder-type a narrow-band filter 82 is formed. These broad-band filter 80 and narrow-band filter 82 are formed so as to have nearly the same center frequency.

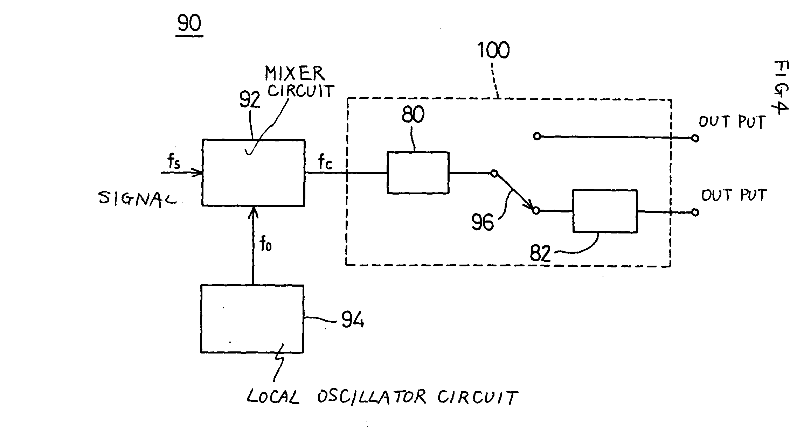

A ladder-type filter 100 using the filter portion 10 of this invention is used, for example, in the signal processing circuit of an intermediate-frequency stage of a communication device as shown in Fig. 4. The signal processing circuit 90 contains a mixer circuit 92 and local oscillator circuit 94, and the output terminal of the mixer circuit 92 is connected to the pattern electrode 14 as the input terminal of the ladder-type filter 100. And the pattern electrode 18 as the output terminal of the broad-band filter 80 and the pattern electrode 20 as the input terminal of the narrow-band filter 82 are connected through a switch 96. Furthermore, in Fig. 4, although the switch 96 is shown as if it is on the same substrate as the filter portion 10, the switch 96 is actually often arranged outside the filter portion.

In the signal processing circuit 90, a reception signal of a frequency $f_s$ is input into the mixer circuit 92 and mixed with a local oscillator signal of a frequency $f_0$ generated at the local oscillator circuit 94. Here, a main signal of the frequency $f_c$ $(= |f_s - f_0|)$ is obtained, and this main signal is input into the ladder-type filter 100. And in accordance with the receiving conditions the switch 96 is manually or automatically shifted. If there is no interference wave, a signal detected at the broad-band filter 80 is output from the switch 96 as it is. Further, if there are any interference waves, then the switch 96 is shifted and the output signal from the broad-band filter 80 is output into the narrow-band filter 82, and the output signal of the narrow-band filter 82 is made available from the pattern electrode 26.

Thus, in the ladder-type filter 100, by shifting the switch 96 a signal can be output from either of the broad-band filter 80 and narrow-band filter 82 in accordance with the receiving conditions. In this ladder-type filter 100, by mounting six laminated-type piezoelectric resonators 44 through 54 vibrating in the length direction on one insulator substrate 12 the filter portion having both of the broad-band filter 80 and narrow-band filter 82 can be made one component part. Because of that, although at least four ladder-type filters were required and at least sixteen piezoelectric resonators of spreading vibration were needed in the past, in the ladder-type filter 100 using the filter portion 10 shown in Fig. 1 the broad-band filter 80 and narrow-band filter 82 can be formed by using six piezoelectric resonators and the cost can be reduced. Furthermore, when the piezoelectric resonators of spreading vibration are used instead of the laminated-type piezoelectric resonators 44 through 54 vibrating in the length direction used in the ladder-type filter 100, the filters can be constructed by using twelve piezoelectric resonators.

Further, when the ladder-type filter 100 of this invention is used as a filter circuit of the signal processing circuit 90, many parts as in the past are not required, and the occupied space by the filter circuit can be reduced because the filter portion 10 of the broad-band filter 80 and narrow-band filter 82 is formed by one component part. In the conventional ladder-type filter, one ladder-type filter has a volume of 6.5 x 6.5 x 7.0 mm $\cong$ 300 mm$^3$ per unit, and in a filter circuit using four ladder-type filters a volume of 1200 mm$^3$ was required. As compared with that, the filter portion 10 used in the ladder-type filter 100 of this invention has a volume of 9.5 x 6.5 x 2.0 $\cong$ 123.5 mm$^3$, and becomes about 1/10 of the conventional filter circuit. Therefore, by using such a ladder-type filter 100, a small-sized communication device can be obtained.

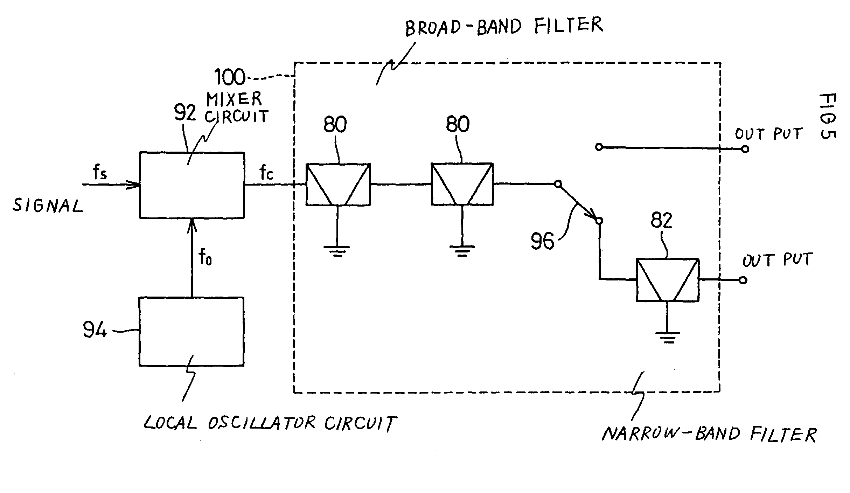

Thus, a broad-band filter 80 and narrow-band filter 82 are formed by piezoelectric resonators connected as a ladder-type on one substrate 12 and accordingly the filter circuit can be made most small-sized, but as shown in Fig. 5 a ladder-type filter 100 may be formed using a broad-band filter 80 and a narrow-band filter 82 as separate parts. In this case, two stages of broad-band filters and one stage of a narrow-band filter are used and the output terminal of the latter broad-band filter 80 is switched to the narrow-band filter 82 or the output terminal by a switch 96.

In such a ladder-type filter 100, when the output signal of the broad-band filter 80 is output directly from the output terminal, the whole ladder-type filter 100 functions as a broad-band filter. Further, when the output signal of the broad-band filter 80 is output through the narrow-band filter 82, the whole ladder-type filter 100 functions as a narrow-band filter. In this way, by making the output signal of the broad-band filter 80 output through the narrow-band filter 82, the narrow-band filter 82 can be made of one stage. Accordingly, as compared with the conventional ladder-type filter where a broad-band filter and narrow-band filter are independently given shown in Fig. 13, the number of stages of narrow-band filters can be decreased.

Furthermore, although it is possible to form a broad-band filter and narrow-band filter on one insulator substrate using piezoelectric resonators of spreading vibration, when the electrical properties are altered it is required to change the dimension of the elements, and according to that the design change of the insulator substrate and pattern electrodes is needed. On the contrary, when the piezoelectric resonators of the laminated-type basic component 60 are used, by changing, for example, the number of layers of piezoelectric layers 62 and internal electrodes 64 it is possible to adjust the electric properties without altering the dimension of the elements. Accordingly, even if the electrical properties are changed, the design change of the insulator substrate 12 and pattern electrodes 14 through 24 is not needed.

Further, in the piezoelectric resonator of spreading vibration, electrodes are formed on both surfaces of the piezoelectric substrate, and accordingly it is difficult to surface-mount the piezoelectric resonator on the pattern electrode on the insulator substrate. As compared with this, in the piezoelectric resonator using the laminated-type basic component, the external electrodes 72 and 74 can be formed on the same surface of the basic component 60 and the piezoelectric resonator can be surface-mounted.

As an example of the ladder-type filter 100, using the piezoelectric resonators having the characteristics as shown in Table 1 a filter portion 10 containing a broad-band filter 80 and narrow-band filter 82 was formed. In Table 1, Fr represents the resonance frequency of a piezoelectric resonator, Fa the antiresonant frequency, and Fa - Fr the difference between them. Further, the between-terminals capacitance means the value of capacitance between the external electrodes 72 and 74 of the piezoelectric resonator. Furthermore, the Qm is the mechanical quality factor.

Table 1

| | | Characteristics of piezoelectric resonator | | | | |
|---|---|---|---|---|---|---|
| | | Fr | Fa | Fa - Fr | Between-terminals capacitance | Qm |
| | | (kHz) | (kHz) | (kHz) | (pF) | |
| Broad-band filter | Element for series connection | 450 | 475 | 25 | 35 | 300 |
| | Element for parallel connection | 425 | 450 | 25 | 700 | 400 |
| Narrow-band filter | Element for series connection | 450 | 462.5 | 12.5 | 35 | 500 |
| | Element for parallel connection | 437.5 | 450 | 12.5 | 700 | 700 |

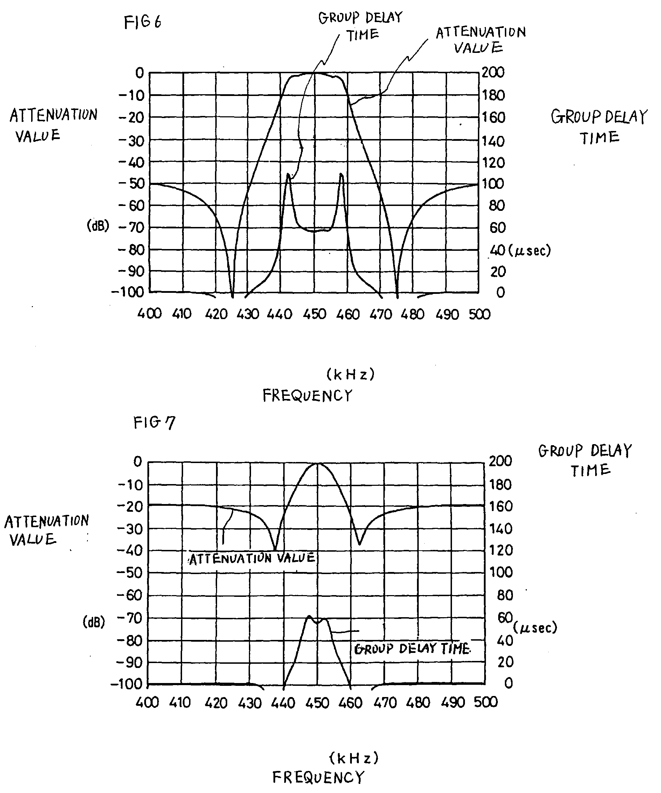

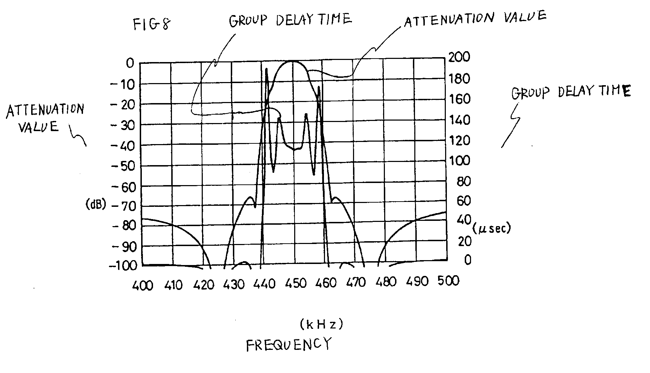

Regarding the ladder-type filter 100 obtained, the filter characteristics were measured and shown in Table 2. Further, the frequency characteristic of the separate broad-band filter 80 is shown in Fig. 6, the frequency characteristic of the separate narrow-band filter 82 is shown in Fig. 8, and the frequency characteristic in the case when the output signal of the broad-band filter 80 is made to pass through the narrow-band filter 82 is shown in Fig. 8. Furthermore, although the characteristic of the separate narrow-band filter 82 is shown in Table and Fig. 7, the narrow-band filter 82 is not individually used in the signal processing circuit of a receiver because the attenuation value of the stopband is low.

Table 2

| | Characteristics of filter | | | | |
|---|---|---|---|---|---|
| | Insertion loss | Attenuation loss | Detuning selectivity | | |
| | | -3(dB) | ±12.5(kHz) | ±25(kHz) | ±100(kHz) |
| | (dB) | (kHz) | (dB) | (dB) | (dB) |
| Broad-band filter | 2.1 | 15.9 | 23.8 | 93.9 | 46.6 |
| Narrow-band filter (separate) | 2 | 7.1 | 37.6 | 21.4 | 18.9 |
| Narrow-band filter (included) | 3.3 | 8.4 | 69.3 | 121.4 | 72.3 |

Furthermore, in Fig. 1 the broad-band filter 80 is composed of the four piezoelectric resonators 44, 46, 48, and 50 and the narrow-band filter 82 is composed of the two piezoelectric resonators 52 and 54, but in accordance with the conditions of usage of the broad-band filter 80 and narrow-band filter 82 may be constructed using piezoelectric resonators of different numbers from the above. However, in ladder-type filters, a combination of one piezoelectric resonator for series connection and one piezoelectric resonator for parallel connection becomes a basic unit, and by connecting a plurality of stages of combinations of these piezoelectric resonators practical characteristics can be obtained. When a plurality of stages of piezoelectric resonators are connected, the stages of a broad-band are arranged on the input side and the stages of a narrow-band are arranged on the output side. This because broad-band characteristics cannot be obtained if the stages of a narrow-band are arranged on the input side.

According to this invention, compared with the conventional ladder-type filters, the number of stages of narrow-band filters can be reduced. Furthermore, by forming a broad-band filter and narrow-band filter on one substrate, the output signal of the mixer circuit in the signal processing circuit of a receiver can be processed with one component part. Therefore, as compared with the conventional cases, the number of parts can be less, and accordingly the space occupied by the filter circuit can be decreased and at the same time the cost can be reduced.

Furthermore, by using the piezoelectric resonator of a laminated type, without changing the dimension of the piezoelectric resonator and substrate the electrical characteristics of the ladder-type filter can be adjusted.

Further, by using such a ladder-type filter, the space occupied by the ladder-type filter can be reduced and a small-sized communication device can be obtained.

While the invention has been particularly shown and described with reference to preferred embodiments, it will be understood by those skilled in the art that the foregoing and other changes in form and details can be made without departing from the spirit and scope of the invention.

**Claims**

1.   A ladder-type filter comprising:

a broad-band filter where a plurality of piezoelectric resonators are connected in series and in parallel as a ladder-type,
one narrow-band filter having nearly the same center frequency as the broad-band filter where a plurality of piezoelectric resonators are connected in series and in parallel as a ladder-type, and
a switch for shifting so as to output the output signal of the broad-band filter directly or through the narrow-band filter,
wherein by making the signal from the broad-band filter output through the narrow-band filter the whole functions as a narrow-band filter.

2.   A ladder-type filter, wherein the broad-band filter and the narrow-band filter are formed on one substrate.

3.   A ladder-type filter as claimed in claim 1 or 2, wherein the piezoelectric resonators used in the broad-band filter and the narrow-band filter contain a basic component where a plurality of piezoelectric layers and internal electrodes are alternately laminated in the length direction, wherein the piezoelectric layers are polarized in the length direction of the basic component, and wherein by applying an electric field between the neighboring internal electrodes the piezoelectric resonator vibrates in the length direction of the basic component.

4. A ladder-type filter as claimed in claim 3, wherein the piezoelectric resonator contains two external electrodes formed on the same surface which are alternately connected to a plurality of the internal electrodes, and wherein the two external electrodes are connected to the pattern electrodes formed on the substrate.

5. A ladder-type filter as claimed in any of claims 1 - 4, wherein the broad-band filter comprises the four piezoelectric resonators connected as a ladder-type, and wherein the narrow-band filter comprises the two piezoelectric resonators connected as a ladder-type.

6. A communication device, wherein a ladder-type filter is contained, and wherein a ladder-type filter as claimed in any of claims 1 - 5 is used.

FIG. 1.

<u>10</u>

FIG 2

44(46,48,50,52,54)

9

FIG 3

<u>10</u>

FIG 4

FIG 5

SIGNAL $f_s$ → MIXER CIRCUIT 92 → $f_c$ → 80 → 80 → 96 → 82 → OUT PUT

BROAD-BAND FILTER

NARROW-BAND FILTER

LOCAL OSCILLATOR CIRCUIT 94 → $f_0$

100

OUT PUT

FIG 6

(kHz)
FREQUENCY

FIG 7

(kHz)
FREQUENCY

13

FIG-8

GROUP DELAY TIME    ATTENUATION VALUE

ATTENUATION VALUE

GROUP DELAY TIME

(dB)

(μsec)

(kHz)
FREQUENCY

FIG 9

1

FIG 10

<u>1</u>

4a                                                     4b

                              4c

FIG 11

                    MIXER
         5         CIRCUIT                    7        FILTER CIRCUIT

                                                                  OUT PUT
   fs                              fc

SIGNAL

              fo

                                    6

LOCAL OSCILLATOR CIRCUIT

FIG 12

BROAD-BAND FILTER

MAIN SIGNAL

ADJACENT INTERFERENCE WAVE

NARROW-BAND FILTER PASS BAND

FREQUENCY

FIG 13